# EUROPÄISCHE PATENTANMELDUNG

(11) **EP 0 687 006 A1**
(43) Veröffentlichungstag der Anmeldung: **13.12.1995**
(21) Anmeldenummer: 95810370.7
(22) Anmeldetag: 07.06.1995
(51) Int. Cl.: H01L 23/467, H01L 23/473, F28F 13/00

(54) **Kühlkörper**

(30) Priorität: 08.06.1994 CH 1806/94
(71) Anmelder: Alusuisse-Lonza Services AG, CH-8212 Neuhausen am Rheinfall (CH)
(72) Erfinder: Glück, Joachim, D-77773 Schenkenzell (DE)

(57) **Zusammenfassung**

Kühlkörper zur konvektiven Kühlung von Oberflächen mittels einem Kühlmittel, enthaltend eine Grundplatte (12) und ein oder mehrere mit der Grundplatte (12) wärmeleitend verbundene Zyklonkühlkörperelemente (20), wobei jedes Zyklonkühlkörperelement (20) einen Hohlkörper (22) mit in einem bestimmten Abstand zur Grundplatte (12) liegenden Kühlmittelöffnungen erster Art (26) zum Durchtritt einer im wesentlichen zur Grundplatte (12) parallel verlaufenden Kühlmittelströmung (16) darstellt, und der Hohlkörper (22) eine oder mehrere weitere Kühlmittelöffnungen zweiter Art (28) aufweist, welche gegenüber dem Abstand der Kühlmittelöffnungen erster Art (26) von der Grundplatte (12) einen geringeren Abstand zur Grundplatte (12) einnehmen und den Durchtritt einer im wesentlichen senkrecht zur Grundplatte verlaufenden Kühlmittelströmung (16) erlauben.

Die Hohlkörper (22) der Zyklonkühlkörperelemente (20) und die Kühlmittelöffnungen (26, 28) sind in Form und Abmessungen sowie der Abstand der Kühlmittelöffnungen (26, 28) zueinander und ihr Abstand zur Grundplatte (12) derart ausgebildet, dass sich die während der konvektiven Kühlung passiv oder aktiv erzeugte Kühlmittelströmung (16) durch das Zyklonkühlkörperelement (20) zwischen den Kühlmittelöffnungen erster und zweiter Art (26, 28) als turbulente Strömung (16) ausbildet.

## Beschreibung

Vorliegende Erfindung betrifft einen Kühlkörper zur konvektiven Kühlung von Oberflächen mittels einem Kühlmittel, wobei der Kühlkörper eine Grundplatte und ein oder mehrere mit der Grundplatte wärmeleitend verbundene Zyklonkühlkörperelemente enthält, und jedes Zyklonkühlkörperelement einen Hohlkörper mit in einem bestimmten Abstand zur Grundplatte liegenden Kühlmittelöffnungen erster Art zum Durchtritt einer im wesentlichen zur Grundplatte parallel verlaufenden Kühlmittelströmung darstellt, und der Hohlkörper eine oder mehrere weitere Kühlmittelöffnungen zweiter Art aufweist, welche gegenüber dem Abstand der Kühlmittelöffnungen erster Art von der Grundplatte einen geringeren Abstand zur Grundplatte einnehmen und den Durchtritt einer im wesentlichen senkrecht zur Grundplatte verlaufenden Kühlmittelströmung erlauben.

Das direkte Kühlen von Oberflächen von beispielsweise wärmeerzeugenden Geräten durch konvektive Kühlung, wobei als Kühlmittel häufig die Umgebungsluft verwendet wird, ist oft ungenügend, da auf diese Weise pro Zeiteinheit zu wenig Wärme abgeführt werden kann. Der Wärmestrom Φ, d.h. die in der Zeit dt unter der Wirkung eines Temperaturgradienten senkrecht durch eine gegebene Fläche A hindurchtretende Wärmemenge dQ, ist definitionsgemäss durch Φ = dQ/dt gegeben, und der entsprechende Wärmefluss j_{Q}, d.h. der senkrecht zur Fläche fliessende Wärmestrom pro Flächeneinheit ist durch j_{Q} = Φ/A definiert. Damit ist der Wärmeübergang einer zu kühlenden Oberfläche auf das Kühlmittel, d.h. die abgeführte Wärme, proportional zu dessen Oberfläche, wobei die dem Kühlmittel ausgesetzte Oberfläche als Kühlfläche bezeichnet wird. Um den Wärmeübergang zu verbessern, werden daher auf die zu kühlende Oberfläche oft Kühlkörper angebracht, welche in bezug auf die zu kühlende Oberfläche eine grössere dem Kühlmittel ausgesetzte Oberfläche (Kühlfläche) zeigen. Solche Kühlkörper dienen somit als Wärmetauscher zwischen der zu kühlenden Oberfläche und dem Kühlmittel.

Kühlkörper zur konvektiven Kühlung von Oberflächen sind seit langem bekannt und bestehen üblicherweise aus gut wärmeleitenden Blechen oder Platten, wie beispielsweise metallenen Blechen, die zur Vergrösserung ihrer Kühlfläche üblicherweise kanalähnliche Vertiefungen bzw. eine aufgesetzte Rippenstruktur aufweisen. Die Wärmeabfuhr der zu kühlenden Oberfläche erfolgt damit durch Wärmeübergang auf den Kühlkörper und anschliessenden Wärmeübergang vom Kühlkörper auf das Kühlmittel durch Konvektion. Der Wärmeübergang von der zu kühlenden Oberfläche auf den Kühlkörper erfolgt dabei durch Wärmeleitung. Um eine hohe Kühlleistung einer solchen Kühlanordnung zu gewährleisten, muss einerseits ein guter Wärmeübergang zwischen der zu kühlenden Oberfläche und dem Kühlkörper sichergestellt werden; andererseits muss der Kühlkörper eine hohe Wärmeleitfähigkeit aufweisen, um eine möglichst homogene Temperaturverteilung im Kühlkörper -- und damit auch eine gute Wärmeleitung an die frei stehenden Rippen -- zu gewährleisten, so dass die ganze dem Kühlmittel ausgesetzte Kühlkörperoberfläche zum Wärmeübergang an das Kühlmittel beiträgt.

Ein konventioneller Kühlkörper besteht somit aus gut wärmeleitfähigem Material und weist einerseits eine mit der zu kühlenden Oberfläche fest verbundene und durch einen guten Wärmeübergang ausgezeichnete Oberfläche auf und enthält andererseits eine meist lamellenförmige, mit dem Kühlmittel in Verbindung stehende, d.h. dem Kühlmittel ausgesetzte, Kühlkörperoberfläche, die sogenannte Kühlfläche.

Der durch das Kühlmittel vom Kühlkörper abgeführte Wärmefluss hängt u.a. neben der Wärmekapazität und der Wärmeleitfähigkeit des Kühlmittels von dem an der Kühlfläche vorbeiziehenden Massenstrom des Kühlmittels ab. Somit ist die Kühlleistung proportional zur mittleren Geschwindigkeit v und der Dichte ρ des Kühlmittels.

Die Strömung des Kühlmittels kann dabei laminar oder turbulent sein. Ein Kriterium für den laminaren bzw. turbulenten Zustand einer Strömung bildet die Reynolds-Zahl Re, welche durch Re = d·v·ρ/η definiert ist, wobei ρ die Kühlmittel-Dichte, v die mittlere Geschwindigkeit des Kühlmittels, d die typische lineare Abmessung des umströmten Körpers (Kühlkörperoberfläche) und η die Viskosität des Kühlmittels bedeuten. Für jede gegebene Oberfläche existiert eine kritische Reynolds-Zahl Reₖᵣᵢₜ. Ist die Reynoldszahl der Kühlmittel-Strömung über einer gegebenen Oberfläche grösser als Reₖᵣᵢₜ, so bildet sich üblicherweise eine turbulente Strömung aus.

Da der vom Kühlkörper abgeführte Wärmefluss wie auch die Reynoldszahl mit zunehmendem ρ·v zunehmen, ergibt sich bei einer turbulent ausgebildeten Kühlmittelströmung eine höhere Kühlleistung.

Die Kühlleistung eines Kühlkörpers, d.h. der von der zu kühlenden Oberfläche abgeführte Wärmefluss, kann durch Vergrösserung der lamellenförmigen Kühlfläche des Kühlkörpers, d.h. durch Verfeinerung des Rippenabstandes und/oder Erhöhung der Rippenstruktur, verbessert werden. Dadurch kann jedoch die für den Kühlvorgang wichtige Oberflächenströmung zu einer laminaren Strömung wechseln. Zur Bildung einer turbulenten Strömung bei gleichzeitig grosser Kühlfläche wird dadurch oft die Verwendung eines Kühlkörpers mit einer nadelförmig ausgebildeten Oberfläche (Nadelkühlkörper) notwendig. Die Herstellung solcher Nadelkühlkörper ist aufgrund ihrer mechanischen Herstellung aufwendig und teuer. Die Verwendung von Nadelkühlkörpern wirkt sich somit insbesondere zur Kühlung von Massenprodukten, wie beispielsweise elektrischen Bauteilen oder elektrischen Schaltungen, nachteilig aus. Zudem zeigen lamellenartige und nadelförmige Kühlkörperoberflächen eine deutliche Abnahme der Kühlleistung in Längsrichtung der Kühlmittelströmung, was zu Hitzeschäden am Kühlkörper und des zu kühlenden Objektes führen kann.

Um eine über die ganze zu kühlende Oberfläche gleichmässig turbulente Kühlmittelströmung zu erhalten, d.h. um eine Abnahme der Kühlleistung in Längsrichtung der Kühlmittelströmung zu verhindern oder zumindest zu verringern, beschreibt die GB 1 356 114 einen Wärmetauscher, bei dem an die zu kühlende Oberfläche eine Turbulenz-Kammer angebracht ist. Die Turbulenz-Kammer enthält zum Einleiten des Kühlmittels an einer zur zu kühlenden Oberfläche entfernt liegenden Wandung einen durch diese führenden rohrförmigen Stutzen und an einer Seitenwandung der Turbulenz-Kammer eine Kühlmittel-Auslassöffnung, welche einen parallel zur zu kühlenden Oberfläche verlaufenden Kühlmittelaustritt ermöglicht. Die Turbulenz-Kammer kann auch eine Vielzahl von Kühlmittel-Einleitstutzen aufweisen, wobei eine Art Vielzahl kleiner Turbulenz-Kammern gebildet wird, die von einer gemeinsamen grossen Kammer mit einer zentralen Kühlmittel-Einleitöffnung und einer gemeinsamen Kühlmittel-Auslassöffnung umfasst wird.

Wesentlich beim Wärmetauscher gemäss der GB 1 356 114 ist die senkrecht auf die zu kühlende Oberfläche auftreffende Kühlmittelströmung, welche durch den rohrförmigen Stutzen unter Druck in die Turbulenzkammer eingeleitet wird, auf die zu kühlende Oberfläche auftrifft, entlang den Seitenwänden der Turbulenzkammer von der zu kühlenden Oberfläche weggeführt und entlang des rohrförmigen Stutzens wieder auf die zu kühlende Oberfläche geleitet wird. Durch den in der GB 1 356 114 beschriebenen Aufbau des Wärmetauschers bildet das Kühlmittel in der Turbulenzkammer einen im wesentlichen stationären, einfachen Wirbel um eine horizontal zur zu kühlenden Oberfläche liegende Achse, so dass das Kühlmittel mehrmals auf die zu kühlende Oberfläche geleitet wird.

Bei Verwendung einer Vielzahl von Kühlmittel-Einlassstutzen sind alle Kühlmittelwirbel im wesentlichen stationär und wandern nur langsam zur gemeinsamen Kühlmittel-Auslassöff nung, so dass insbesondere bei dieser Ausführungsform des als Kühlkörper ausgebildeten Wärmetauschers gemäss der GB 1 356 114 jeder Kühlmittelwirbel mehrmals auf die zu kühlende Oberfläche geleitet wird. Damit eignet sich ein als Kühlkörper ausgebildeter Wärmetauscher gemäss der GB 1 356 114 nicht zur Kühlung grösserer Oberflächen oder zum Abführen grosser Wärmemengen. Zudem erlaubt ein derart ausgebildeter Wärmetauscher mit grossen Abmessungen der Turbulenzkammer keine über die zu kühlende Oberfläche homogene Wärmeentnahme. Im weiteren wird bei einem Wärmetauscher gemäss der GB 1 356 114 mit einer Vielzahl von Kühlmittel-Einlassstutzen -- bedingt durch die zentrale Kühlmittel-Einleitöffnung -- der Bau grossflächiger, flacher Kühlkörper verunmöglicht.

Gemäss der GB 1 356 114 wird in der Turbulenzkammer eine laminare Strömung mit einem im wesentlichen stationären Kühlmittelwirbel gebildet. Dieser Mangel versucht der Gegenstand der EP-A 0 483 108 zu überwinden.

Die EP-A 0 483 108 beschreibt ein Kühlmodul für Elektronikkomponenten, wobei auf die Rückseite einer Leiterplatte ein speziell ausgebildetes, zylinderförmiges Kühlmodul aufgebracht wird. Das zylinderförmige Kühlmodul weist eine Wärmeübertragungsplatte und einen darauf angeordneten hohlzylinderförmigen Körper mit einer Eintritts- und Austrittsöffnung für ein Kühlmittel auf. Das Einleiten des Kühlmittels geschieht derart, dass das Kühlmittel im wesentlichen senkrecht auf die Wärmeübertragungsplatte auftrifft. Durch eine speziell ausgestaltete Oberfläche der Wärmeübertragungsplatte wird eine teilweise kontrollierbare, turbulente Kühlmittelströmung erzeugt. Wesentliches Merkmal beim Gegenstand gemäss der EP-A 0 483 108 ist die speziell ausgestaltete Oberfläche der Wärmeübertragungsplatte, wobei diese auf der dem Kühlmittel zugewandten Seite konzentrische, ringförmige Rippen aufweist.

Beim Kühlkörper gemäss der EP-A 0 483 108 trifft das Kühlmittel in einer laminaren Strömung auf die Wärmeübertragungsplatte und wird erst durch die konzentrischen Rippen in eine turbulente Strömung versetzt. Durch die vertikale Anströmung der Rippen bildet sich im allgemeinen keine über die ganze Wärmeübertragungsplatte gleichmässige turbulente Strömung, d.h. die Kühlleistung des zylinderförmigen Kühlkörpers ist radial inhomogen, was sich insbesondere bei Kühlkörpern mit grossem Radius negativ auswirkt.

Zur Kühlung von grösseren zu kühlenden Oberflächen beschreibt die EP-A 0 483 108 einen Kühlkörper mit einer Vielzahl von Kühlmittel-Eintrittsöffnungen, wobei eine Vielzahl von Verwirbelungsbereichen gebildet wird. Dadurch ergibt sich als weiterer Nachteil eine bezüglich der ganzen zu kühlenden Oberfläche inhomoge Wärmeentnahme durch das Kühlmittel, da -- bedingt durch die gemeinsame Kühlmittel-Austrittsöffnung -- Kühlmittel, welches nach dem Auftreffen auf die Wärmeübertragungsplatte erwärmt wird, im nächsten Verwirbelungsbereich wiederum auf die Wärmeübertragungsplatte geleitet wird.

Eine weitere Ausgestaltung eines Kühlkörper für elektronische Schaltungen wird in der EP-A 0 590 636 beschrieben, wobei der Kühlkörper im wesentlichen aus zwei konzentrisch angeordneten hohlzylinderförmigen Körpern auf einer gemeinsamen Grundplatte besteht und der innere hohlzylinderförmige Körper eine Abdeckung aufweist, welche von einem rohrförmigen Kühlmitteleinlass durchstossen wird. Als wesentliches Merkmal enthält der innere hohlzylinderförmige Körper eine Vielzahl von radialen Kühlmittel-Austrittsöffnungen, welche das aus dem inneren Körper austretende Kühlmittel strahlenförmig auf die innere Oberfläche des äusseren Körpers leiten. Beim Kühlkörper gemäss der EP-A 0 590 636 wird das Kühlmittel durch den rohrförmigen Kühlmitteleinlass in den inneren hohlzylinderförmigen Körper eingeleitet, wonach das Kühlmittel in einer laminaren Strömung auf die Grundplatte trifft und danach auf die Innenfläche des äusseren hohlzylinderförmigen Körpers geleitet wird. Dadurch wird keine wirklich turbulente Strömung ausgebildet, insbesondere nicht innerhalb des inneren hohlzylinderförmigen Körpers, wodurch die Kühlleistung für gewisse Anwendungen, beispielsweise für Körper mit hoher Wärmeabgabe oder grosser zu kühlender Oberflächen, zu gering ausfällt.

Aufgabe vorliegender Erfindung ist es, einen Kühlkörper zu schaffen, der oben beschriebene Nachteile vermeidet und die auf die Flächeneinheit bezogene Kühlleistung erhöht bzw. welcher der von der zu kühlenden Oberfläche abzuführenden Wärmemenge optimal angepasst ist.

Erfindungsgemäss wird dies dadurch erreicht, dass die Hohlkörper der Zyklonkühlkörperelemente und die Kühlmittelöffnungen in Form und Abmessungen sowie der Abstand der Kühlmittelöffnungen zueinander und ihr Abstand zur Grundplatte derart ausgebildet sind, dass sich die während der konvektiven Kühlung passiv oder aktiv erzeugte Kühlmittelströmung durch das Zyklonkühlkörperelement zwischen den ersten und zweiten Kühlmittelöffnungen als turbulente Strömung ausbildet.

Als Kühlmittel können beliebige Kühlflüssigkeiten oder Kühlgase verwendet werden. Der erfindungsgemässe Gegenstand ist jedoch insbesondere geeignet zur konvektiven Kühlung mittels Luftkühlung, wobei bevorzugt die Umgebungsluft des zu kühlenden Gegenstandes als Kühlmittel verwendet wird.

Durch den erfindungsgemässen Kühlkörper wird eine Abnahme der Kühlleistung des Kühlkörpers in Strömungsrichtung des Kühlmittels verhindert. Zudem gewährleistet die konvektive Kühlung mittels einer turbulenten Kühlmittelströmung eine über die Kühlfläche jedes Zyklonkühlkörperelementes homogen verteilte Wärmeabfuhr und eine optimale Wärmeübertragung von der Kühlfläche des Kühlkörpers auf das Kühlmittel.

Die Grundplatte kann Teil eines zu kühlenden Bauteils oder Gerätes sein, oder als separates Teil mit der zu kühlenden Oberfläche in Kontakt gebracht werden. Bevorzugt wird die Grundplatte jedoch als separates Teil ausgebildet. Die Grundplatte wird dabei zweckmässigerweise mechanisch fest mit der zu kühlenden Oberfläche verbunden. Das form- und/oder kraftschlüssige Festlegen der Grundplatte mit der zu kühlenden Oberfläche kann durch mechanische Mittel wie beispielsweise durch Verklemmen, Verstemmen, Verkeilen, Verspannen, Schrauben, Nieten oder durch Löten, Schweissen oder Verkleben geschehen.

Die Grundplatte des erfindungsgemässen Kühlkörpers kann eine beliebige Form aufweisen. Insbesondere kann sie eben oder gewölbt sein. Wesentlich ist jedoch, dass die mit der zu kühlenden Oberfläche zusammenstossende Oberfläche des Kühlkörpers eine möglichst vollständige Überdeckung aufweist. Die Wanddicke der Grundplatte kann gleichmässig oder lokal unterschiedlich sein, so dass der Abstand der Kühlfläche des Kühlkörpers zur zu kühlenden Oberfläche gleichmässig sein kann oder aber beliebig geformte Wölbungen aufweisen kann.

Die Grundplatte kann auch mit Öffnungen zum Durchtritt des Kühlmittels versehen sein. Dies kann insbesondere bei der Kühlung des Gehäuses eines wärmeerzeugenden Gerätes sinnvoll sein, bei dem dadurch beispielsweise erhitzte Luft aus dem Geräteinnern durch die Öffnungen der Grundplatte strömen kann.

Zweckmässigerweise besteht die Grundplatte aus gut wärmeleitendem Material, vorzugsweise aus metallischen Werkstoffen und insbesondere aus Kupfer oder Aluminium oder deren Legierungen.

Der Begriff Zyklon bezeichnet in der Technik üblicherweise einen Wirbler oder Fliehkraftabscheider, d.h. ein Gerät zum Klassieren oder Sortieren von in Gasen oder Flüssigkeiten dispergierten Stoffen, wobei die Trennung unter der Wirkung von Zentrifugalkräften erfolgt. Die Zentrifugalkräfte werden dabei durch das tangentiale Einströmen der zu trennenden Stoffe in ein zylindrisches Einlaufgehäuse erzeugt und führen die Teilchen mit grösserer Masse in einer schraubenförmigen Strömung an die Wandung, an die sie ihre kinetische Energie abgeben und längs der sie in einen Trichter abrutschen. Die leichteren Teilchen werden durch ein von oben in den zylindrischen Teil ragendes Tauchrohr ausgetragen. Solche Zyklone werden auch zur Vorentstaubung von stark staubhaltigen oder mit luftverschmutzenden Partikeln beladenen Abgasen grossindustriell eingesetzt, wobei die Zyklone eine Grösse von teilweise mehrerern 10 m³ erreichen können. Allein zum Zweck der Kühlung, insbesondere zur Kühlung von elektrischen Bauelementen, wurden Zyklone bisher nicht eingesetzt.

Die Hohlkörper der Zyklonkühlkörperelemente können bezüglich ihrer Form beliebig ausgestaltet sein. Die Zyklonkühlkörperelemente können als einzelne Hohlkörper mit entsprechenden Kühlmittelöffnungen vorliegen, oder sie können aus einem ein- oder zweiseitig offenen Gebilde mit entsprechenden Kühlmittelöffnungen geschaffen werden, welche erst durch Aufbringen auf die Grundplatte und gegebenenfalls durch Verschliessen der der Grundplatte gegenüberliegenden offenen Seite mittels einer Abdeckung einen Hohlkörper bilden, wobei im letzten Fall die Abdeckung die Kühlmittelöffnungen zweiter Art enthält. Ein einseitig offenes Gebilde kann beispielsweise einen tassenförmigen Körper darstellen, wobei seine Grundfläche beispielsweise eine Einstülpung mit Kühlmittelöffnungen zweiter Art aufweist. Ein zweiseitig offenes Gebilde kann beispielsweise eine hohlzylinderförmige Ummantelung mit Kühlmittelöffnungen erster Art darstellen.

Die Hohlkörperabdeckungen können aus beliebigem Werkstoff geschaffen sein, insbesondere müssen sie nicht speziell gut wärmeleitfähig sein, wobei der Werkstoff derart gewählt werden muss, dass er die entsprechenden Kühlmitteltemperaturen -- ohne Schaden zu nehmen -- erträgt. Demnach eignen sich als Werkstoff für die Abdeckungen beispielsweise Metalle oder Kunststoffe.

Das Aufbringen der Zyklonkühlkörperelemente auf die Grundplatte oder das Verschliessen von ein- oder zweiseitig offenen Gebilden stellt jeweils eine form- und/oder kraftschlüssig festgelegte Verbindung dar, die beispielsweise durch Verklemmen, Verstemmen, Verkeilen, Verspannen, Schrauben, Nieten oder durch Löten, Schweissen oder Verkleben geschehen kann.

Die Zyklonkühlkörperelemente können auch aus der Grundplatte ausgearbeitete, einseitig offene Gebilde darstellen, deren Öffnungen anschliessend mittels einer Abdeckung verschlossen werden, wobei die aus der Grundplatte ausgearbeiteten Gebilde die Kühlmittelöffnungen erster Art und die Abdeckungen die Kühlmittelöffnungen zweiter Art enthalten. Die aus der Grundplatte ausgearbeiteten Gebilde können beispielsweise durch Stanzen, Bohren, Fräsen oder Tiefziehen hergestellte Gebilde sein.

Die Zyklonkühlkörperelemente sind bis auf die Kühlmittelöffnungen im wesentlichen dicht geschlossene Körper, d.h. das Festlegen eines ein- oder zweiseitig offenen Gebildes mit der Grundplatte und gegebenenfalls mit der Abdeckung stellt im wesentlichen ein dichtes Verschliessen dar, wobei nicht eine absolute Dichtheit notwendig ist. Vielmehr genügt jeweils ein form- und/oder kraftschlüssiges Festlegen in der Weise, dass im Vergleich zur Kühlmittelströmung durch die Kühlmittelöffnungen kein wesentlicher Kühlmitteldurchtritt durch die Hohlkörperbegrenzungen stattfinden kann.

Wesentlich für- den erfindungsgemässen Gegenstand ist auch, dass die Zyklonkühlkörperelemente wärmeleitend mit der Grundplatte verbunden sind, so dass der erfindungsgemässe Kühlkörper eine Grundplatte und ein oder mehrere mit der Grundplatte wärmeleitend verbundene Zyklonkühlkörperelemente enthält. Die Zyklonkühlkörperelemente selbst bestehen zweckmässigerweise aus gut wärmeleitfähigem Material, vorzugsweise aus metallischen Werkstoffen, und dabei insbesondere aus Kupfer oder Aluminium sowie deren Legierungen.

Die Ausbildung der verschiedenen Zyklonkühlkörperelemente eines Kühlkörpers kann gleichmässig sein, oder es können Zyklonkühlkörperelemente verschiedenster Ausgestaltung auf derselben Kühlkörper-Grundplatte kombiniert werden. Zudem können die Zyklonkühlkörperelemente regelmässig oder unregelmässig über die ganze Grundplatte verteilt sein. Insbesondere kann die Verteilungsdichte der Zyklonkühlkörperelemente entsprechend der von der zu kühlenden Oberfläche abzuführenden Wärme gewählt werden. Dadurch entstehen partiell dichtere Anordnungen von Zyklonkühlkörperelementen, die lokal stärker gekühlte Stellen schaffen. In einer weiteren bevorzugten Anordnung der Zyklonkühlkörperelemente werden in Strömungsrichtung des Kühlmittels die Zyklonkühlkörperelemente zunehmend dichter angeordnet, wodurch eine in Strömungsrichtung möglicherweise steigende Kühlmitteltemperatur aufgefangen werden kann.

Wesentliches Merkmal des Kühlkörpers gemäss vorliegender Erfindung ist die Ausgestaltung der Zyklonkühlkörperelemente in der Weise, dass sich eine turbulente Kühlmittelströmung im gesamten im Hohlkörper zwischen den Kühlmittelöffnungen erster und zweiter Art liegenden Strömungsbereich ausbildet. Dies kann beispielsweise durch Einleiten des Kühlmittels durch die Kühlmittelöffnungen erster Art geschehen, wobei unter Einleiten des Kühlmittels, beispielsweise Luft, durch die Kühlmittelöffnungen erster Art das Einbringen des Kühlmittels durch beispielsweise Einblasen, oder durch Absaugen des Kühlmittels über eine oder mehrere Kühlmittelöffnungen zweiter Art verstanden wird.

In einer bevorzugten Ausführungsform des erfindungsgemässen Kühlkörpers können zur Beeinflussung der Kühlmittelströmung, insbesondere im Bereich der Kühlmittelöffnungen, an den Wandungen der Zyklonkühlkörperelemente festgelegte Anformungen zur Beeinflussung der Kühlmittelströmung, wie beispielsweise entsprechend geformte Kühlmittelleitbleche oder rohrförmige Anformungen, angebracht sein. Solche Anformungen erlauben beispielsweise die Ausbildung einer turbulenten Strömung vor dem Kühlmitteleintritt in den Hohlkörper des Zyklonkühlkörperelementes oder das Einleiten des Kühlmittels durch die Kühlmittelöffnung erster Art tangential an die Innenfläche des Hohlkörpers.

Beim Einleiten des Kühlmittels in den Hohlkörper durch die Kühlmittelöffnungen zweiter Art kann das Erfordernis der turbulenten Kühlmittelströmung zwischen den Kühlmittelöffnungen erster und zweiter Art beispielsweise durch Anbringen speziell ausgebildeter, vom Hohlkörper abragender Anformungen an die Kühlmittelöffnungen zweiter Art erreicht werden, wodurch die Kühlmittelströmung jeweils bereits vor dem Durchtritt der Kühlmittelöffnung zweiter Art, d.h. vor dem Einleiten in den Hohlkörper, in eine turbulente Strömung versetzt wird.

Bei Zyklonkühlkörperelementen, die an der Kühlmittelöffnung erster Art eine Anformung aufweisen, welche bezüglich der Innenfläche des Hohlkörpers ein tangentiales Einleiten des Kühlmittels erlauben, wird das Kühlmittel in einer turbulenten, schraubenförmigen Bewegung nach unten auf die Grundplatte und in einer weiterhin turbulent verlaufenden schraubenförmigen Strömung senkrecht nach oben durch die Kühlmittelöffnungen zweiter Art geführt. Die Ausbildung der Turbulenz hängt dabei beispielsweise von der Rauhheit der Innenfläche des Hohlkörpers, der Kühlmittel-Einleitgeschwindigkeit und der Viskosität des eingesetzten Kühlmittels ab. Zur Verstärkung der Turbulenz können die Innenflächen der Hohlkörper eine speziell ausgestaltete Oberflächenstruktur, beispielsweise eine gewellte Struktur, aufweisen.

Bei Zyklonkühlkörperelementen, die an der Kühlmittelöffnung erster Art eine Anformung aufweisen, welche einen tangential zur Innenfläche des Hohlkörpers verlaufenden Durchtritt des Kühlmittels erlauben, verläuft die mittlere Hauptbewegung der turbulenten Kühlmittelströmung im Hohlkörper des Zyklonkühlkörperelementes schraubenförmig von der Kühlmittelöffnung erster Art nach unten zur Grundplatte und dann schraubenförmig um die durch das Zentrum der Kühlmittelöffnung zweiter Art führende vertikale Achse nach oben oder in umgekehrter Richtung von der Kühlmittelöffnung zweiter Art schraubenförmig zur Grundplatte und dann in einer durch die Innenfläche des Hohlkörpers geführten Bewegung schraubenförmig nach oben zur Kühlmittelöffnung erster Art, wobei im letzteren Fall das Kühlmittel den Hohlkörper tangential zu dessen Innenfläche verlässt. Beim tangentialen Durchtritt des Kühlmittels durch die Kühlmittelöffnungen erster Art bildet sich somit selbständig eine Drallströmung innerhalb der Ummantelung des Zyklonkühlkörperelementes aus, die sich im Gegenstromprinzip bis zur Hohlraum-Begrenzung auf der Grundplatte erwärmt. Die dadurch hervorgerufene turbulente Kühlmittelströmung weist eine mittlere Hauptströmung auf, welche schraubenförmig verläuft und mit der Grundplatte einen spitzen Winkel, beispielsweise einen Winkel zwischen 5° und 80° und insbesondere einen Winkel zwischen 10 und 60° einschliesst, wobei sich die Winkelangaben auf einen Vollkreis von 360° beziehen.

Beim tangentialen Einleiten des Kühlmittels durch die Kühlmittelöffnungen erster Art verlässt das erwärmte Kühlmittel das Zyklonkühlkörperelement -- ohne Berührung mit der zu kühlenden Ummantelung des Zyklonkühlkörperelementes -- zentrisch durch die Kühlmittelöffnung zweiter Art.

Da zum Kühlen einer erhitzten Oberfläche die Temperatur des Kühlmittels stets tiefer liegen muss als die Temperatur der zu kühlenden Oberfläche und beim Einsatz eines Kühlkörpers als Wärmetauscher der entsprechende Wärmübergang durch Wärmeleitung auf den Kühlkörper and anschliessende Wärmeabgabe der Kühlfläche auf das Kühlmittel erfolgt, kann das sich einstellende Temperaturgefälle infolge der lokalen Oberflächentemperatur der Kühlfläche gegenüber dem Kühlmittel durch ein Feld von Temperaturgradienten beschrieben werden.

Unter passiv erzeugter Kühlmittelströmung wird im vorliegenden Text nun der durch das Feld der Temperaturgradienten zwischen der Kühlfläche des Kühlkörpers und dem Kühlmittel erzeugte konvektive Massenfluss des Kühlmittels verstanden, der sich stets entsprechend dem Verlauf des Temperaturgradientenfeldes ausbildet.

Unter aktiv erzeugter Kühlmittelströmung wird im vorliegenden Text stets die durch äussere Einwirkungen, wie beispielsweise durch die Wirkung eines in der Kühlmittelströmung vorhandenen Gebläse oder Ventilators, gebildete Kühlmittelströmung verstanden.

Das Einführen des Kühlmittels durch die Kühlmittelöffnungen zweiter Art bedingt die Herstellung eines Überdruckes an den Kühlmittelöffnungen zweiter Art, d.h. die Bildung einer aktiv erzeugten Kühlmittelströmung. Das tangentiale Einführen des Kühlmittels durch die Kühlmittelöffnungen erster Art hat demgegenüber den Vorteil, dass sich im Zyklonkühlkörperelement -- bedingt durch das Temperaturgradientenfeld im Zyklonkühlkörperelement -- auch ohne Druckbeaufschlagung des Kühlmittels an der Kühlmittel-Einlassöffnung eine passiv erzeugte Kühlmittelströmung ausbildet. Dies erhöht wesentlich die Betriebssicherheit eines derart betriebenen Kühlkörpers, da bei einem allfälligen Ausfall einer aktiv vorgenommenen Drucküberhöhung, beispielsweise bei einem Stromausfall für einen Ventilator, der Kühlkörper weiterhin arbeitet.

In einer besonders vorteilhaften Ausführungsform des erfindungsgemässen Kühlkörpers weisen die Kühlmittelöffnungen zweiter Art jeweils ein die Wandung des Hohlkörpers dicht durchstossendes Tauchrohr als Anformung auf, wobei die im Hohlraum befindliche Öffnung des Tauchrohres die Kühlmittelöffnung zweiter Art bildet. Bevorzugt verläuft dabei die Achse jedes Tauchrohres im wesentlichen senkrecht zur Grundplatte. Die Tauchrohre weisen beispielsweise vorteilhaft eine hohlzylinderförmige Gestalt auf.

Unter dem Abstand einer Kühlmittelöffnung von der Grundplatte wird in vorliegendem Text stets der entsprechende Zentrumsabstand der Kühlmittelöffnung verstanden.

Die Länge des in den Hohlraum eines Zyklonkühlkörperelementes ragenden Tauchrohrabschnittes beträgt vorzugsweise 1/3 bis 2/3 der Höhe, d.h. der maximalen, vertikal zur Grundplatte gemessenen Abmessung des entsprechenden Hohlkörpers.

Insbesondere bei Verwendung der Kühlmittelöffnungen zweiter Art zum Einleiten des Kühlmittels, sind die Innenflächen der Tauchrohre bevorzugt derart beschaffen, dass das Kühlmittel während dem Durchfliessen der Tauchrohre in eine turbulente Strömung versetzt wird.

In einer weiteren vorteilhaften Ausführungsform des erfindungsgemässen Kühlkörpers wird der Hohlraum jedes Zyklonkühlkörperelementes durch einen hohlzylinderförmigen Körper, der einerseits durch die Grundplatte und andererseits durch eine allen Zyklonkühlkörperelementen gemeinsame, beispielsweise parallel zur Grundplatte verlaufende Deckplatte begrenzt, wobei jedes Zyklonkühlkörperelement ein Tauchrohr aufweist, das die Deckplatte dicht durchstösst. Die räumliche Begrenzung der Zyklonkühlkörperelemente zwischen den Platten, d.h. die Form der Innenfläche des hohlzylinderförmigen Körpers, kann dabei eine beliebige Form annehmen. Die Deckplatte kann eine ebene, beispielsweise parallel zur Grundplatte verlaufende Platte sein, oder aber eine, beispielsweise parallel zur Grundplatte verlaufende, nicht ebene Platte mit beliebigen Wölbungen darstellen.

Die Wände der einzelnen Zyklonkuhlkörperelemente können an ihrem gesamten Umfang, d.h. ihrer gesamten Ummantelung, eine gleichmässige Wanddicke aufweisen oder eine unterschiedliche Wandstärke zeigen. Insbesondere kann sich die Wanddicke der Ummantelung des Hohlraumes, beispielsweise zwischen der Grund- und einer Deckplatte, von der Grundplatte weg verjüngen und so eine gute Wärmeleitung in der Hohlraum-Ummantelung gegen aussen hin, d.h. in Richtung Deckplatte, sicherstellen.

Vorliegende Erfindung umfasst Zyklonkühlkörperelemente mit beliebig geformten Hohlkörpern mit erfindungsgemässen Kühlmittelöffnungen. Folglich kann die räumliche Begrenzung der Hohlkörper zwischen der Grund- und einer beispielsweise gemeinsamen Deckplatte eine beliebig geformte Hohlraum-Ummantelung mit entsprechenden Kühlmittelöffnungen darstellen. Beispielsweise können die Hohlraum-Ummantelungen zwischen der Grund- und einer beispielsweise gemeinsamen Deckplatte die Form eines Zylinders mit kreisförmiger (Kreiszylinder), dreieckformiger (Prisma) oder viereckförmiger (Quader, Spat) Grundfläche als auch mit einer Grundfläche eines sonstigen konvexen oder nicht-konvexen Polygons annehmen. Bevorzugt weisen die Hohlraum-Ummantelungen eine rotationssymmetrische Form auf. In einer besonders bevorzugten Ausführungsform sind die Hohlraum-Ummantelungen der Zyklonkühlkörperelemente gegenüber einer auf der Grundplatte senkrecht liegenden Achse rotationssymmetrisch, beispielsweise zylinder-, kegelstumpf- oder bauchförmig.

Die Innen- und/oder Aussenwände der Hohlraum-Ummantelungen können beispielsweise glatt, gewellt, gezackt, genutet oder gebeult sein.

In einer weiteren besonders bevorzugten Ausführungsform des erfindungsgemässen Gegenstandes, enthält ein aus einer Grund- und einer gemeinsamen Deckplatte mit dazwischenliegenden Zyklonkühlkörperelementen gebildeter Kühlkörper Seitenwände, so dass sich ein durch die Grund- und Deckplatte sowie die Seitenwände begrenztes Kühlgehäuse ausbildet, das an wenigstens einer der Seitenwände oder der Grundplatte mindestens eine Kühlgehäuseöffnung zum Durchtritt der Kühlmittelströmung aufweist.

Ein Kühlkörper mit Kühlgehäuse enthält beispielsweise die Gesamtheit der auf der Grundplatte befindlichen Zyklonkühlkörperelemente, wobei die ersten Kühlmittelöffnungen der Zyklonkühlkörperelemente allesamt innerhalb des Kühlgehäuses liegen. Vom erfindungsgemässen Gegenstand sind jedoch auch Kühlkörper umfasst, bei denen ein Kühlgehäuse nur einen Teil der auf der Grundplatte befindlichen Zyklonkühlkörperelemente umfasst.

Bei einem Kühlkörper mit Kühlgehäuse wird durch das sich während dem Kühlprozess gebildete Temperaturgradientenfeld eine passive Kühlmittelströmung ausgebildet, bei der das Kühlmittel durch die Kühlmittelöffnungen zweiter Art aus dem Kühlgehäuse austritt und sich infolge der dadurch hervorgerufenen Sogwirkung eine laminare oder turbulente Kühlmittelströmung von der Kühlgehäuseöffnung/en in Richtung der Kühlmittelöffnungen erster Art bildet.

An die Kühlgehäuseöffnung/en kann auch eine Ventilator mit saugender oder blasender Wirkung und gegebenenfalls ein Reduzierventil angebracht werden. Bei blasender Ausführung des Ventilatiors wird das Kühlmittel aktiv in das Kühlgehäuse befördert, wobei die passive Kühlmittelströmung verstärkt wird. Um bei einem saugenden Ventilator eine aktive Kühlmittelströmung aus den Kühlgehäuseöffnungen zu erreichen, muss hingegen die passive Kühlmittelströmung überwunden werden.

In einer weiteren bevorzugten Ausführungsform des erfindungsgemässen Gegenstandes wird ein Ventilator und gegebenenfalls zusätzlich ein Reduzierventil über der Deckplatte angeordnet, wobei zwischen der Deckplatte und dem Ventilator eine Druckkammer geschaffen wird, die die Kühlmittelöffnungen zweiter Art der Zyklonkühlkörperelemente miteinander verbindet.

Die Grund- und Deckplatten und/oder die Kühlgehäuse können beliebige Abmessungen aufweisen. Bevorzugt werden diese Abmessungen jedoch derart gewählt, dass Standardventilatoren mit einer Kupplungsfläche, d.h. einer Kontaktfläche zwischen Ventilator (-Gehäuse) und Kühlgehäuse bzw. Deckplatte, von beispielsweise 60 mm x 60 mm, 80 mm x 80 mm, 100 mm x 100 mm oder mehrere Standardventilatoren mit einer gesamten Kupplungsfläche mit einem Vielfachen obiger Linearabmessungen, beispielsweise 60 mm x 120 mm, 60 mm x 180 mm oder 80 mm x 160 mm, eingesetzt werden können.

Ein Ventilator zur aktiven Bildung einer Kühlmittelströmung bzw. zur Unterstützung der passiven Kühlmittelströmung kann jedoch auch bei erfindungsgemässen Kühlkörpern ohne Kühlgehäuse angewendet werden, wobei dessen Wirkungsgrad entsprechend geringer ausfällt.

Die Erfindung betrifft auch ein Verfahren zur Herstellung eines erfindungsgemässen Kühlkörpers mit Zyklonkühlkörperelementen, die Tauchrohre und eine gemeinsame Deckplatte enthalten, wobei die zwischen der Grund- und Deckplatte liegenden Wandungen der Hohlkörper durch Tiefziehen der Grundplatte und/oder die Tauchrohre durch Tiefziehen der Deckplatte geschaffen werden, die tiefgezogenen Teile mit den Kühlmittelöffnungen versehen werden und die derart geformten Grund- und Deckplatten miteinander dicht gefügt werden. Die Herstellung der für den erfindungsgemässen Kühlkörper benötigten Kühlmittelöffnungen erfolgt dabei bevorzugt vorgängig zum Fügen der tiefgezogenen Grund- und/oder Deckplatten durch beispielsweise mechanische Mittel, wie Bohren oder Fräsen.

Eine andere bevorzugte Herstellung von erfindungsgemässen Kühlkörpern mit Zyklonkühlkörperelementen, die Tauchrohre und eine gemeinsame Deckplatte enthalten, geschieht durch Tiefziehen der Deckplatte in der Weise, dass die Herstellung der zwischen der Grund- und Deckplatte liegenden Wandungen der Hohlkörper sowie der Tauchrohre im selben Tiefzieh-Arbeitsgang erfolgt und die tiefgezogene Deckplatte mit den Kühlmittelöffnungen erster und zweiter Art versehen wird und nachfolgend mit der Grundplatte dicht gefügt wird. Die Herstellung der erfindungsgemässen Kühlmittelöffnungen geschieht bevorzugt vorgängig zum Fügen der tiefgezogenen Deckplatte mit der Grundplatte durch beispielsweise mechanische Mittel, wie Bohren oder Fräsen.

Der erfindungsgemässe Kühlkörper eignet sich bevorzugt zum Kühlen von elektrischen Bauelementen oder elektrischen Schaltungen.

Weitere Vorteile, Merkmale und Einzelheiten der Erfindung ergeben sich aus den nachfolgenden beispielhaften Figuren.

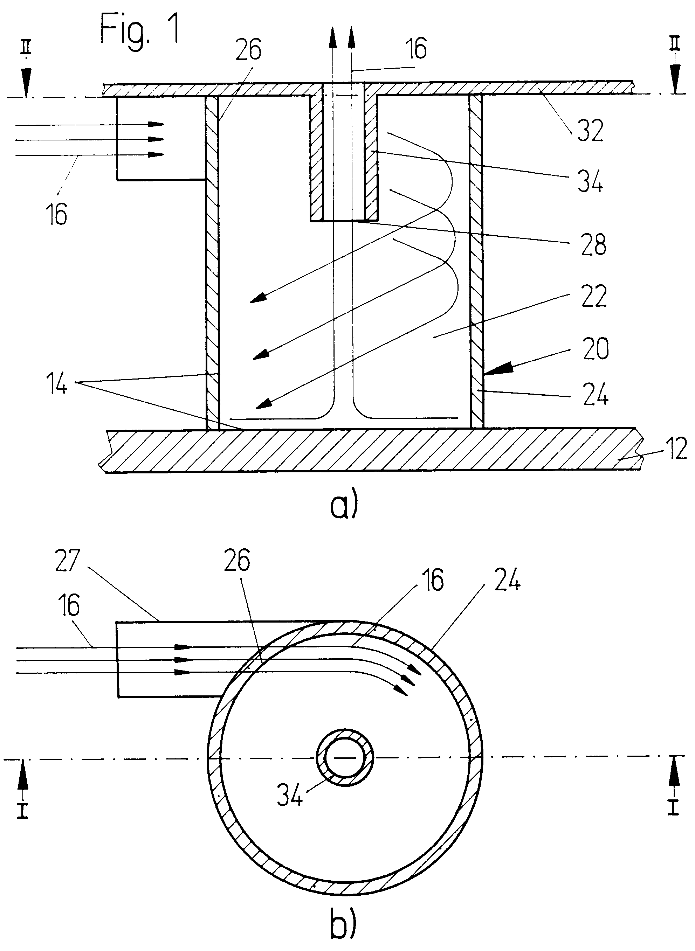

Figur 1 zeigt einen aus einer Grund- 12 und Deckplatte 32 mit dazwischenliegenden hohlzylinderförmigen Zyklonkühlkörperelementen 20 gebildeten Kühlkörper, wobei in Figur 1 beispielhaft nur ein einzelnes Zyklonkühlkörperelement 20 dargestellt ist. Dabei zeigt Figur 1 a) die Draufsicht auf einen Längsschnitt durch die Mittelachse des Zyklonkühlkörperelementes 20, d.h. einen Schnitt entlang der Achse I-I in Figur 1 b). Figur 1 b) zeigt einen Querschnitt durch das Zyklonkühlkörperelement 20 entlang der Achse II-II in Figur 1 a).

Der Hohlkörper 22 wird einerseits durch eine hohlzylinderförmige Ummantelung 24 und andererseits durch die Begrenzungsflächen der Grund- 12 und Deckplatten 32 gebildet. In den Hohlkörper 22 ragt ein die Deckplatte 32 durchstossendes Tauchrohr 34, dessen untere Öffnung, d.h. die im Hohlkörper 22 liegende Öffnung, eine Kühlmittelöffnung zweiter Art 28 darstellt. Diese weist gegenüber der Kühlmittelöffnung erster Art 26 einen geringeren Abstand zur Grundplatte 12 auf. Die Kühlmittelöffnung erster Art 26 weist zudem eine rohrförmige Anformung 27 zum tangentialen Einleiten des Kühlmittels auf. Das eine Ende der rohrförmigen Anformung 27 liegt dicht gefügt an der Aussenfläche der Hohlkörper-Ummantelung 24 und umgibt die Kühlmittelöffnung erster Art 26.

Figur 1 zeigt weiter den Verlauf der mittleren Hauptbewegungsrichtung der turbulenten Kühlmittelströmung 16 in einem derart ausgebildeten Kühlkörper. Dieser Strömungsverlauf 16 entspricht beispielsweise der während des Kühlvorganges sich bildenden passiven Kühlmittelströmung 16. Durch die warme Grundplatte 12 wird das Kühlmittel an der Kühlfläche 14 erwärmt und verlässt -- dem Temperaturgradientenfeld folgend -- durch das Tauchrohr 34, resp. durch die Kühlmittelöffnung zweiter Art 28, den Hohlkörper 22. Durch die Sogwirkung des aus dem Hohlkörper 22 austretenden Kühlmittels strömt vergleichsweise kühles Kühlmittel durch die Kühlmittelöffnungen erster Art 26 nach.

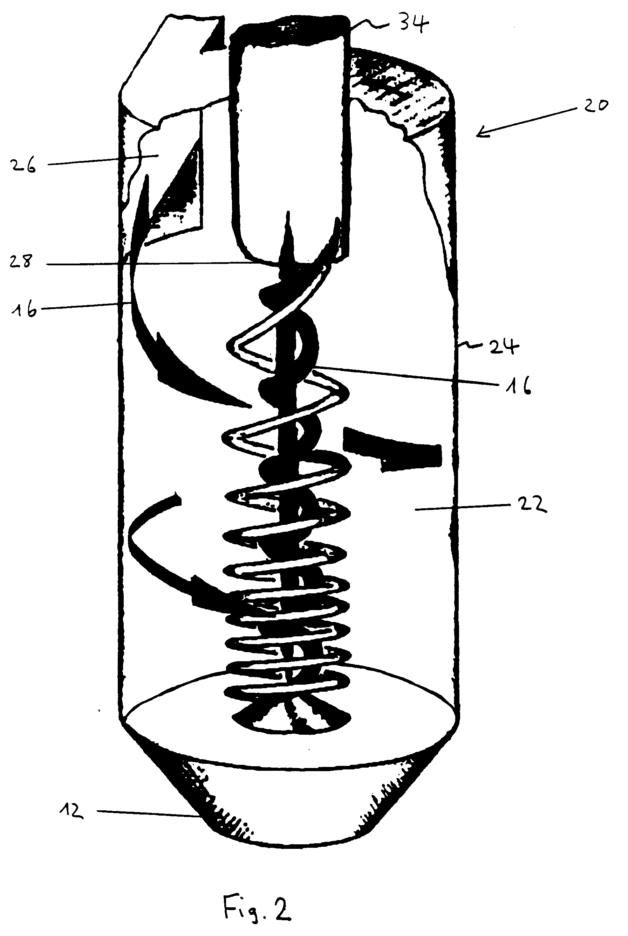

In Figur 2 ist der Strömungsverlauf des Kühlmittels in einem Zyklonkühlkörperelement 20 mit hohlzylinderförmiger Ummantelung 24 und einem ebenfalls hohlzylinderförmigen Tauchrohr 34 schematisch dargestellt. Das Kühlmittel strömt durch die Kühlmittelöffnung erster Art 26 tangential in den Hohlkörper 22 ein und verlässt den Hohlkörper 22 durch die Kühlmittelöffnung zweiter Art 28. Da der Abstand der Kühlmittelöffnung zweiter Art 28 zur Grundplatte 12 geringer ist als der entsprechende Abstand der Kühlmittelöffnung erster Art 26, wird das Kühlmittel anfänglich, d.h. nach Eintritt in den Hohlkörper 22, zu einer schraubenförmigen, auf die Grundplatte 12 gerichteten turbulenten Strömung 16 gezwungen und tritt anschliessend in einer entgegengesetzt gerichteten, vertikalen und turbulenten Strömung 16 durch das Tauchrohr 34 nach aussen.

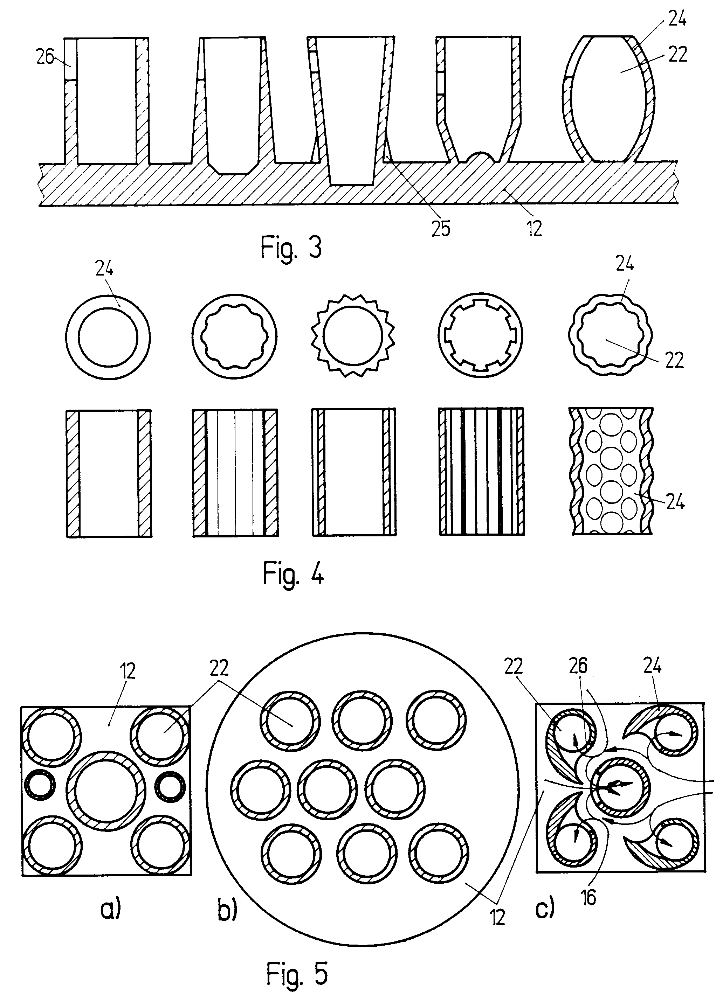

In Figur 3 sind Längsschnitte von verschieden geformten Hohlkörper-Ummantelungen 24 mit ersten Kühlmittelöffnungen 26 auf derselben Grundplatte 12 dargestellt. Die in Figur 3 dargestellten beispielhaften Hohlkörper-Ummantelungen 24 weisen alle eine bezüglich ihren Längsachsen rotationssymmetrische Form auf (von links nach rechts: Hohlzylinder mit gleichmässiger Wanddicke, Hohlzylinder mit einer sich von unten nach oben verjüngenden Wanddicke, nach oben sich erweiternder Kegelstumpf mit Verstärkungselementen 25 zwischen Ummantelung 24 und Grundplatte 12, trapezförmiger und bauchiger Längsschnitt mit gleichmässiger Wanddicke). Wie beim sich nach oben erweiternden kegelstupfförmigen Hohlkörper 22 beispielhaft dargestellt, können zur Verbesserung des Wärmeübergangs zwischen der Grundplatte 12 und dem Zyklonkühlkörperelement 20 Verstärkungselemente 25 ausgebildet sein. Figur 3 zeigt zudem, dass die Begrenzung der Hohlkörper 22 auf der Grundplatte 12 nicht eben sein muss, sondern -- wie beispielhaft dargestellt -- vertieft oder herausgeformt sein kann.

Figur 4 zeigt beispielhafte Ausgestaltungen der Hohlraum-Ummantelung 24 von Zyklonkühlkörperelementen 20. In der oberen Hälfte der Fig. 4 sind jeweils die Querschnitte der Hohlraum-Ummantelungen 24 und in der unteren Bildhälfte die entsprechenden Längsschnitte der Hohlkörper 22 dargestellt. Die in Figur 4 dargestellten Ummantelungen 24 zeigen von links nach rechts eine beidseitig glatte, eine aussen glatte und innen gewellte, eine aussen gezackte und innen glatte, eine aussen glatte und innen genutete Oberfläche sowie eine gebeulte Ummantelung 24.

Figur 5 zeigt beispielhaft eine Draufsicht auf drei verschiedene Anordnungen der Hohlkörper 22 von Zyklonkühlkörperelementen 20 mit zylinderförmigem Hohlraum auf einer Grundplatte 12. Die Verteilung der Hohlkörper 22 kann unregelmässig wie in Bild 5 a) sein, wobei die Hohlkörper 22 in ihrer Grösse und Ausgestaltung ebenfalls unterschiedlich sein können. Figur 5 b) zeigt eine im wesentlichen gleichmässige Anordnung von identischen Hohlkörpern 22. In Figur 5 c) ist beispielhaft eine Anordnung von Hohlkörpern 22 mit kreiszylinderförmigen Hohlräumen dargestellt, wobei die Hohlkörper 22 an den Ummantelungen 24 speziell ausgebildete Anformungen 27 aufweisen bzw. die Ummantelungen 24 speziell geformt sind, so dass die Aussenflächen der Ummantelungen 24 die Kühlmittelströmung 16 in Richtung der Kühlmittelöffnungen erster Art 26 gemäss vorbestimmtem Strömungsverhalten beeinflussen.

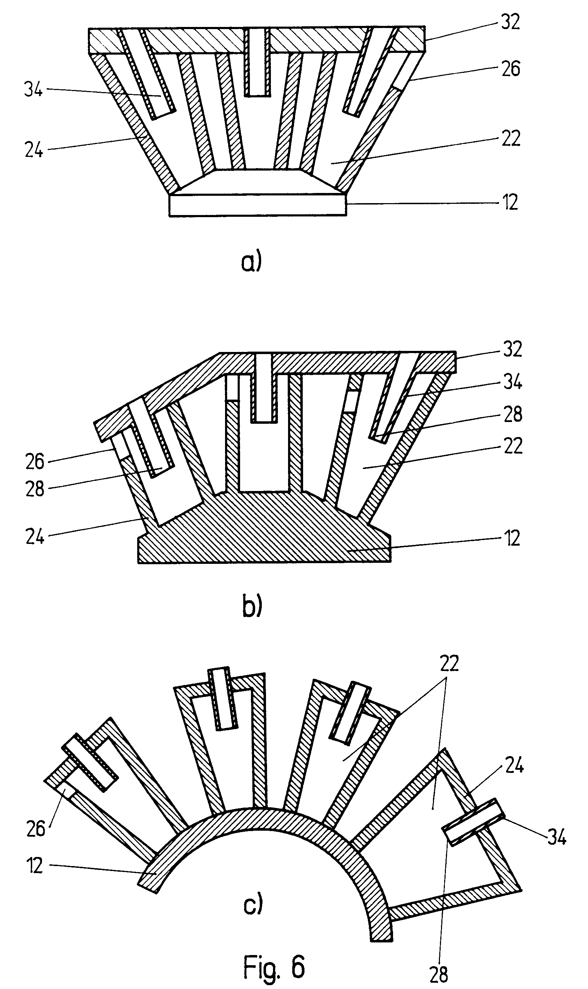

Figur 6 zeigt Längsschnitte von weiteren, gemäss dem erfindungsgemässen Gegenstand geformten Kühlkörpern.

Figur 6 a) veranschaulicht einen Längsschnitt durch einen Kühlkörper mit kegelstumpfförmig ausgebildeten Zyklonkühlkörperelementen 20, deren Hohlräume 22 jeweils durch die Grundplatte 12 und eine gemeinsame ebene Deckplatte 32 begrenzt sind. Dabei weisen die randständig auf der Grundplatte angeordneten Hohlkörper 22 eine schief-kegelstumpfförmige Gestalt auf.

Figur 6 b) zeigt einen Längsschnitt durch einen weiteren speziell ausgestalteten Kühlkörper mit auf einer gemeinsamen Grundplatte angeordneten hohlzylinder- und kegelstumpfförmigen Hohlkörpern 22, deren Ummantelungen 24 Kühlmittelöffnungen erster Art 26 enthalten. Dabei nimmt der Längsschnitt der Grundplatte die Form eines auf ein Rechteck aufgesetzten, gleichschenkligen Trapezes an, wobei auf jeder Schenkelseite des Trapezes sowie auf der oberen Trapezseite jeweils ein Längsschnitt eines Hohlkörpers 22 dargestellt ist. Die Hohlkörper 22 sind auf der der Grundplatte gegenüberliegenden Seite durch eine gemeinsame Deckplatte 32 begrenzt, welche eine abgewinkelte Gestalt aufweist, d.h. der Teil der Deckplatte 32, welcher die linken und mittleren Hohlkörper 22 abdeckt, weist eine zur darunterliegenden Grundplatte 12 parallele Gestalt auf. Die in Fig. 6 b) dargestellte Deckplatte 32 zeigt zudem tauchrohrförmige Einstülpungen 34, deren in den Hohlkörpern liegenden Öffnungen die Kühlmittelöffnungen zweiter Art 28 darstellen.

Figur 6 c) zeigt einen Längsschnitt durch einen Kühlkörper mit gebogener Grundplatte 12 und kegelstumpfförmigen Hohlkörpern 22, wobei die Hohlkörper 22 kegelstumpfförmige, tassenartige Gebilde darstellen, die mit ihren offenen Seiten auf der gemeinsamen Grundplatte festgelegt sind. Die Grundseite der tassenartigen Gebilde ist jeweils von einem Tauchrohr durchsetzt, wobei die gegen den Hohlkörper ragende Öffnung jedes Tauchrohres jeweils die Kühlmittelöffnung zweiter Art 28 bildet. Der wandseitige Teil jedes tassenartigen Gebildes weist zudem wenigstens eine Kühlmittelöffnung erster Art 26 auf, wobei in Figur 6 c) nur eine Kühlmittelöffnung erster Art 26 beim ganz links liegenden Hohlkörper 22 eingezeichnet ist. Figur 6 c) verdeutlicht somit beispielhaft, dass die Grundplatte 12 nicht zwangsläufig eben sein muss, sondern beliebig gebogen sein kann und zudem einen beliebig ausgebildeten Querschnitt aufweisen kann.

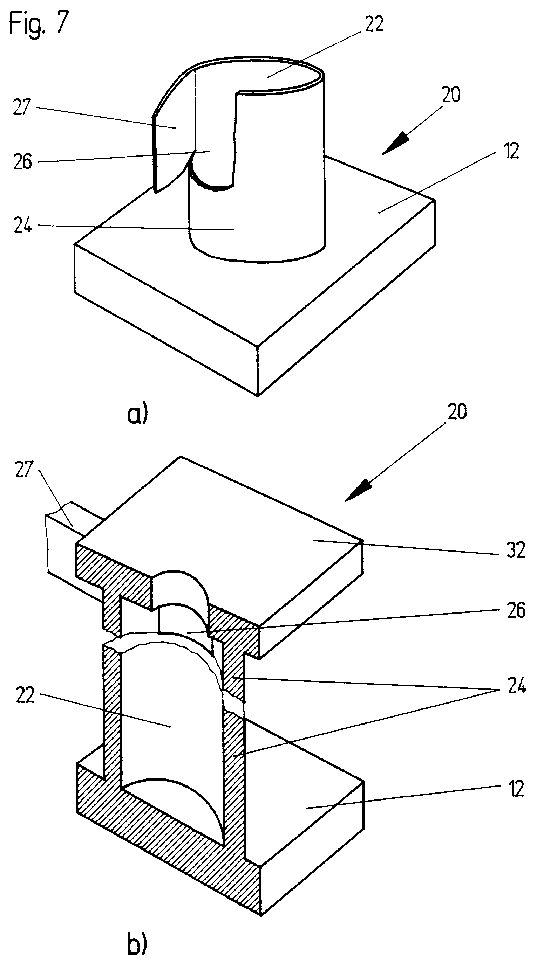

Figur 7 zeigt perspektivische Ansichten zweier verschiedener Ausführungsformen von Zyklonkühlkörperelementen 20, die jeweils eine Kühlmittelöffnung erster Art 26 mit einer Anformung 27 zur Beeinflussung der Kühlmittelströmung 16 aufweisen.

Figur 7 a) zeigt eine perspektivische Ansicht einer auf einer Grundplatte 12 befindlichen hohlzylinderförmigen Ummantelung 24 eines Zyklonkühlkörperelementes 20, wobei dessen Deckplatte 32 mit den Kühlmittelöffnungen zweiter Art 28 nicht dargestellt ist. An der Kühlmittelöffnung erster Art 26 ist ein Kühlmittelleitblech 27 zur Beeinflussung des Kühlmittelströmungsverlaufes 16 festgelegt. Das Kühlmittelleitblech 27 kann -- wie in Figur 7 a) beispielhaft dargestellt -- aus einem Teil der Ummantelung 24 bestehen und beispielsweise durch Auftrennen der Ummantelung 24 und nachfolgendes Biegen aus dieser herausgearbeitet sein, oder es kann ein entsprechendes Kühlmittelleitblech 27 getrennt hergestellt und beispielsweise an der Ummantelung 24 im Bereich der Kühlmittelöffnung erster Art 26 durch beispielsweise Schweissen, Löten, Kleben, Schrauben oder Nieten festgelegt werden.

Figur 7 b) zeigt einen perspektivisch dargestellten Längsschnitt durch ein Zyklonkühlkörperelement 20, bei dem ein Teil der hohlzylinderförmigen Ummantelung 24 auf der Grundplatte 12 festgelegt bzw. aus dieser herausgearbeitet ist, und ein zweiter Teil der hohlzylinderförmigen Ummantelung 24 auf der Deckplatte 32 festgelegt bzw. aus dieser herausgearbeitet ist, und der zweite Teil der hohlzylinderförmigen Ummantelung 24 die Kühlmittelöffnungen erster Art 26 mit einer Anformung 27 zur Beeinflussung der Anströmung des Zyklonkühlkörperelementes 20 enthält. Das in Figur 7 b) dargestellte Zyklonkühlkörperelement 20 zeigt ebenfalls eine mittig in den Hohlzylinder 22 führende Öffnung in der Deckplatte 32, in welche beispielsweise ein Tauchrohr 34 (nicht dargestellt) zur Herstellung einer Kühlmittelöffnung zweiter Art 28 eingeführt werden kann.

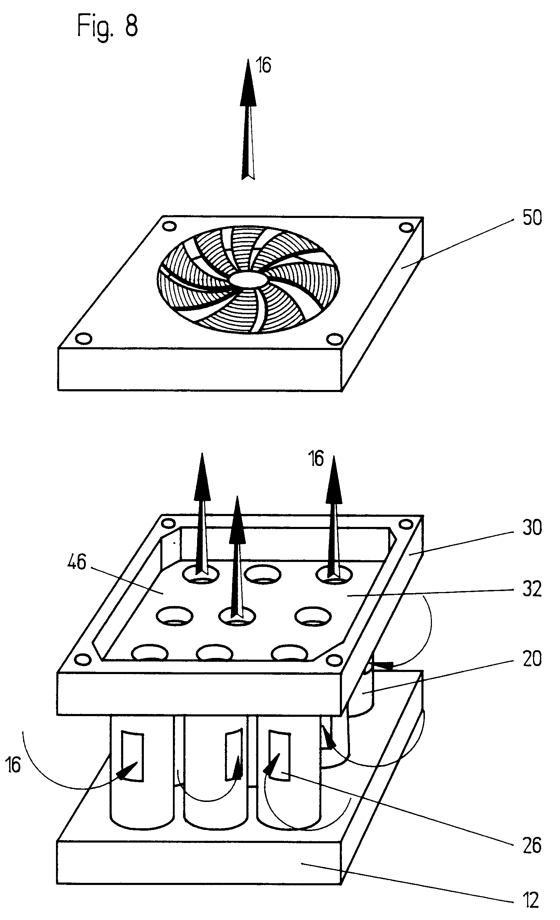

Figur 8 zeigt eine perspektivische Ansicht eines Kühlkörpers, enthaltend eine ebene Grundplatte 12 und hohlzylinderförmige Zyklonkühlkörperelemente 20, die an ihrer Ummantelung 24 mit Kühlmittelöffnungen erster Art 26 versehen sind. Zudem enthält der in Figur 8 dargestellte Kühlkörper eine speziell geformte, allen Zyklonkühlkörperelementen 20 gemeinsame Abdeckung 30, die im wesentlichen einstückig als Deckplatte 32 mit einer seitlichen Umrandung ausgeführt ist. Auf diese Abdeckung 30 kann, beispielsweise durch Verschrauben, ein Ventilator 50 an die Umrandung der Deckplatte 32 dicht gefügt werden, so dass dadurch eine Druckkammer 46 gebildet wird. Durch diesen Aufbau des Kühlkörpers wird das durch die Kühlmittelöffnungen zweiter Art 28 strömende Kühlmittel 16 in die Druckkammer 46 geführt und durch einen gemeinsamen Ventilator 50 nach aussen, d.h. aus dem Kühlkörper, befördert.

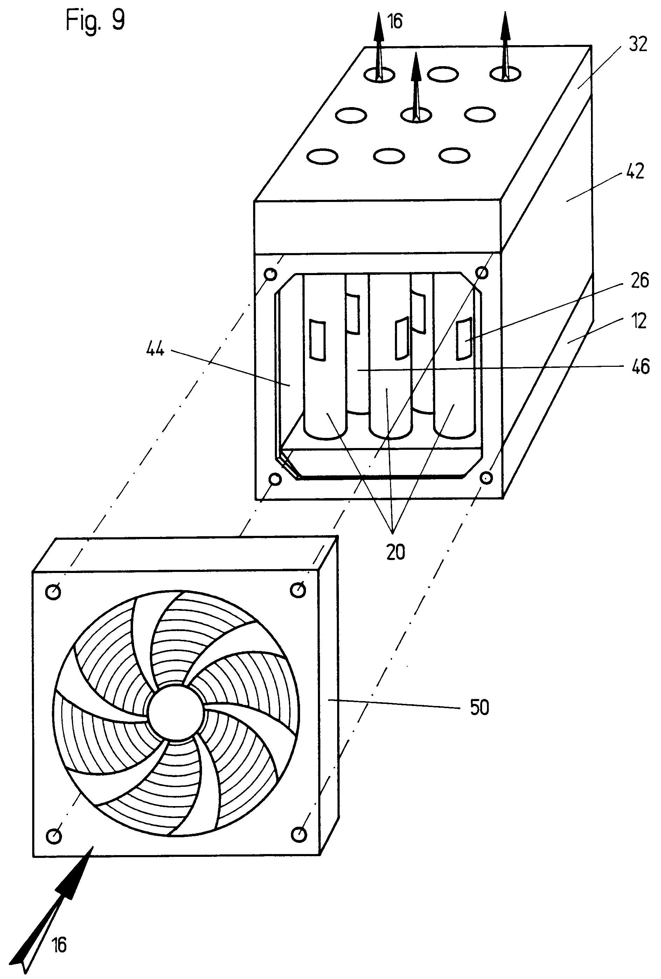

Figur 9 stellt eine perspektivische Ansicht eines Kühlkörpers mit einem Kühlgehäuse dar. Der Kühlkörper enthält eine ebene Grundplatte 12, hohlzylinderförmige Zyklonkühlkörperelemente 20 mit die Deckplatte 32 durchstossenden Tauchrohren 34, sowie die Deckplatte 32 selbst. Zudem enthält der Kühlkörper ein Kühlgehäuse, das durch die Grund- 12 und Deckplatte 32 sowie daran festgelegte Seitenwände 42 gebildet wird, wobei eine Seitenwand 42 fehlt, d.h. dass diese Fläche die Kühlgehäuseöffnung 44 bildet, und an diese Fläche ein Ventilator 50 an das Kühlgehäuse dicht festgelegt werden kann. Der in Figur 9 dargestellte Ventilator 50 ist eine blasende Ausführung, d.h. das Kühlmittel wird in das Kühlgehäuse geblasen und tritt durch die Kühlmittelöffnungen erster Art 26 in die Zyklonkühlkörperelemente 20 ein. Nachdem das Kühlmittel in einer turbulenten Strömung 16 die Zyklonkühlkörperelemente 20 durchströmt hat, gelangt es durch die Tauchrohre 34 direkt nach aussen. In dieser Ausführungsform bildet der Hohlraum zwischen dem Kühlgehäuse und den Ummantelungen 24 der Zyklonkühllrörperelemente 20 eine Druckkammer 46.

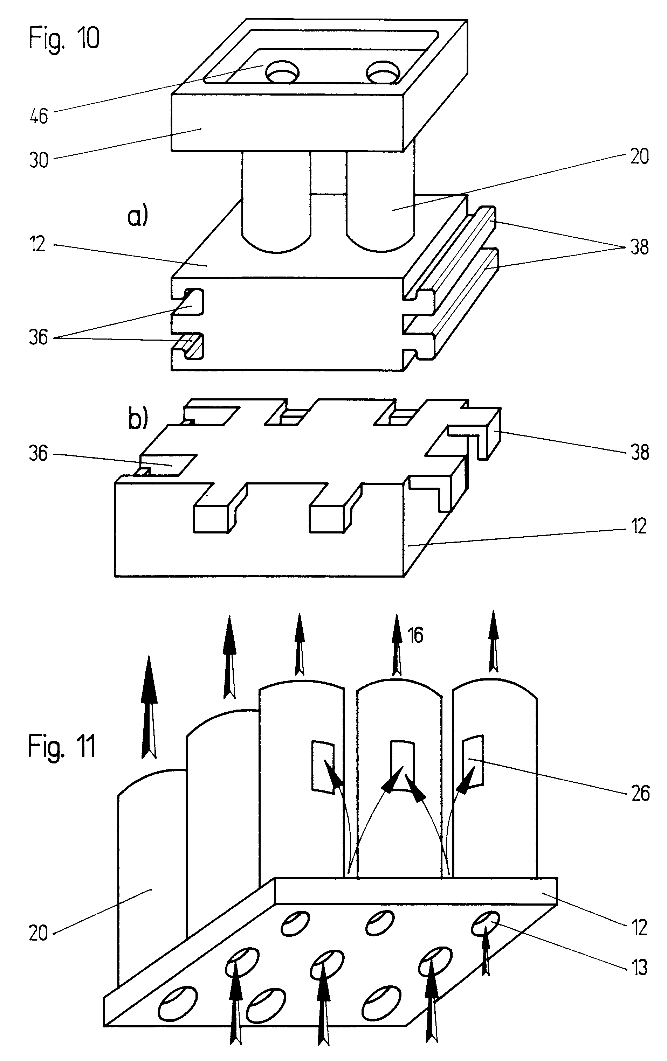

Figur 10 a) zeigt eine perspektivische Ansicht eines Kühlkörpers in Modulbauweise. Der dargestellte Kühlkörper enthält beispielhaft zwei hohlzylinderförmige Zyklonkühlkörperelemente 20 mit einer gemeinsamen Abdeckung 30, sowie eine speziell ausgearbeitete Grundplatte 12. Die Grundplatte 12 zeigt auf der einen Seite nutenförmige Ausnehmungen 36 und auf der gegenüberliegenden Seite federartige Anformungen 38, so dass verschiedene modular gebaute Kühlkörperelemente, beispielsweise durch seitliches Ineinanderschieben, zu einem grösseren Kühlkörper zusammengebaut werden können. Figur 10 b) zeigt beispielhaft eine perspektivische Ansicht einer anderen, für die modulare Bauweise geeigneten Grundplatte 12. Diese weist auf zwei Seiten hacken- oder krallenförmige Anformungen 38 und auf den anderen Seiten entsprechend komplementäre Ausnehmungen 36 auf, so dass mehrere solcher modularer Grundplatten 12 miteinander durch Verhacken festgelegt werden können.

Figur 11 zeigt eine perspektivische Ansicht eines aus einer ebenen Grundplatte 12 mit hohlzylinderförmigen Zyklonkühlkörperelementen 20 bestehenden Kühlkörpers. Der in Figur 11 dargestellte Kühlkörper zeigt eine Grundplatte 12 mit Öffnungen 13 zum Durchtritt des Kühlmittels. Dies kann insbesondere bei der Kühlung des Gehäuses eines wärmeerzeugenden Gerätes sinnvoll sein, bei dem dadurch beispielsweise erhitzte Luft aus dem Geräteinnern durch die Öffnungen 13 der Grundplatte 12 strömen kann.

Der erfindungsgemässe Kühlkörper weist einen einfachen Aufbau auf, wodurch auf kostengünstige Weise die auf die Flächeneinheit bezogene Kühlleistung erhöht werden kann. Insbesondere können auch grossflächige Kühlkörper mit auf die von der zu kühlenden Oberfläche abzuführenden Wärmemenge optimal angepassten Eigenschaften gebaut werden. Der erfindungsgemässe Kühlkörper eignet sich speziell zur kostengünstigen und optimalen Kühlung von elektrischen Schaltungen, elektrischen Bauelementen und insbesondere von integrierten Schaltungen, bei denen eine hohe und lokal unterschiedliche Kühlleistung erforderlich ist.

## Patentansprüche

1. Kühlkörper zur konvektiven Kühlung von Oberflächen mittels einem Kühlmittel, wobei der Kühlkörper eine Grundplatte (12) und ein oder mehrere mit der Grundplatte (12) wärmeleitend verbundene Zyklonkühlkörperelemente (20) enthält, und jedes Zyklonkühlkörperelement (20) einen Hohlkörper (22) mit in einem bestimmten Abstand zur Grundplatte (12) liegenden Kühlmittelöffnungen erster Art (26) zum Durchtritt einer im wesentlichen zur Grundplatte (12) parallel verlaufenden Kühlmittelströmung (16) darstellt, und der Hohlkörper (22) eine oder mehrere weitere Kühlmittelöffnungen zweiter Art (28) aufweist, welche gegenüber dem Abstand der Kühlmittelöffnungen erster Art (26) von der Grundplatte (12) einen geringeren Abstand zur Grundplatte (12) einnehmen und den Durchtritt einer im wesentlichen senkrecht zur Grundplatte (12) verlaufenden Kühlmittelströmung (16) erlauben,
dadurch gekennzeichnet, dass
die Hohlkörper (22) der Zyklonkühlkörperelemente (20) und die Kühlmittelöffnungen (26, 28) in Form und Abmessungen sowie der Abstand der Kühlmittelöffnungen (26, 28) zueinander und ihr Abstand zur Grundplatte (12) derart ausgebildet sind, dass sich die während der konvektiven Kühlung passiv oder aktiv erzeugte Kühlmittelströmung (16) durch das Zyklonkühlkörperelement (20) zwischen den ersten und zweiten Kühlmittelöffnungen (26, 28) als turbulente Strömung (16) ausbildet.

2. Kühlkörper nach Anspruch 1, dadurch gekennzeichnet, dass die Anordnung einer Vielzahl von Zyklonkühlkörperelementen (20) auf der Grundplatte (12) derart vorgenommen wird, dass die Verteilungsdichte der Zyklonkühlkörperelemente (20) proportional der von der zu kühlenden Oberfläche abzuführenden Wärmemenge ist.

3. Kühlkörper nach Anspruch 1, dadurch gekennzeichnet, dass die Wandungen (12, 24, 32) der Zyklonkühlkörperelemente (20), insbesondere im Bereich der Kühlmittelöffnungen (26, 28), eine oder mehrere Anformungen (27) zur Beeinflussung der Kühlmittelströmung (16) aufweisen.

4. Kühlkörper nach Anspruch 3, dadurch gekennzeichnet, dass die Kühlmittelöffnungen zweiter Art (28) jeweils ein die Wandung (32) des Hohlkörpers (22) dicht durchstossendes Tauchrohr (34) als Anformung (27) aufweisen, wobei die im Hohlraum befindliche Öffnung des Tauchrohres (34) die Kühlmittelöffnung zweiter Art (28) bildet.

5. Kühlkörper nach Anspruch 4, dadurch gekennzeichnet, dass die Innenflächen der Tauchrohre (34) derart beschaffen sind, dass das Kühlmittel während dem Durchfliessen der Tauchrohre (34) in eine turbulente Strömung (16) versetzt wird.

6. Kühlkörper nach Anspruch 4, dadurch gekennzeichnet, dass der Hohlraum jedes Zyklonkühlkörperelementes (20) durch einen hohlzylinderförmigen Körper (22), der einerseits durch die Grundplatte (12) und andererseits durch eine allen Zyklonkühlkörperelementen (20) gemeinsame, beispielsweise parallel zur Grundplatte (12) verlaufende Deckplatte (32) begrenzt wird, und jedes Zyklonkühlkörperelement (20) ein Tauchrohr (34) aufweist, das die Deckplatte (32) dicht durchstösst.

7. Kühlkörper nach Anspruch 6, dadurch gekennzeichnet, dass der Kühlkörper Seitenwände (42) enthält, so dass sich ein durch die Grund- (12) und Deckplatte (32) sowie die Seitenwände (42) begrenztes Kühlgehäuse ausbildet, das an wenigstens einer der Seitenwände (42) oder der Grundplatte (12) mindestens eine Kühlgehäuseöffnung (44, 13) zum Durchtritt der Kühlmittelströmung (16) aufweist.

8. Kühlkörper nach Anspruch 7, dadurch gekennzeichnet, dass an die Kühlgehäuseöffnungen (44, 13) ein Ventilator (50) mit saugender oder blasender Wirkung und gegebenenfalls ein Reduzierventil angebracht ist.

9. Kühlkörper nach Anspruch 7, dadurch gekennzeichnet, dass ein Ventilator (50) und gegebenenfalls ein Reduzierventil über der Deckplatte (32) angeordnet ist, wobei zwischen der Deckplatte (32) und dem Ventilator (50) eine Druckkammer (46) geschaffen wird, die die Kühlmittelöffnungen zweiter Art (28) der Zyklonkühlkörperelemente (20) miteinander verbindet.

10. Verwendung der Kühlmittelöffnungen erster Art (26) des Kühlkörpers nach einem der Ansprüche 1 bis 9 zum tangentialen Einleiten des Kühlmittels in die Zyklonkühlkörperelemente (20).

11. Verwendung des Kühlkörpers nach einem der Ansprüch 1 bis 10 zum Kühlen von elektrischen Schaltungen oder elektrischen Bauelementen und insbesondere von integrierten Schaltungen.

12. Verfahren zur Herstellung eines Kühlkörpers gemäss Anspruch 6, dadurch gekennzeichnet, dass die zwischen der Grund- (12) und Deckplatte (32) liegenden Wandungen (24) der Hohlkörper (22) durch Tiefziehen der Grundplatte (12) und/oder die Tauchrohre (34) durch Tiefziehen der Deckplatte (32) geschaffen werden, die tiefgezogenen Teile (12, 32) mit den Kühlmittelöffnungen (26, 28) versehen werden und die derart geformten Grund- (12) und Deckplatten (32) miteinander dicht gefügt werden.

13. Verfahren zur Herstellung eines Kühlkörpers gemäss Anspruch 6, dadurch gekennzeichnet, dass die zwischen der Grund- (12) und Deckplatte (32) liegenden Wandungen (24) der Hohlkörper (22) sowie die Tauchrohre (34) in einem Arbeitsgang durch Tiefziehen der Deckplatte (32) geschaffen werden, die tiefgezogene Deckplatte (32) mit den Kühlmittelöffnungen erster und zweiter Art (26, 28) versehen wird und nachfolgend mit der Grundplatte (12) dicht gefügt wird.
